# FASCICULE DE BREVET EUROPEEN

(11) **EP 2 141 809 B1**
(45) Date de publication et mention de la délivrance du brevet: **21.08.2019**
(21) Numéro de dépôt: 09164448.4
(22) Date de dépôt: 02.07.2009
(51) Int. Cl.: H03K 17/96, G02B 5/124

(54) **APPAREILLAGE ÉLECTRIQUE DE TYPE TERMINAL POUR LE BÂTIMENT COMPRENANT UN COMPOSANT ÉLECTRIQUE**
Elektrogerät vom Typ Endgerät für Gebäude, das mindestens eine elektrische Komponente enthält
Electrical switchgear such as a terminal for construction comprising an electrical component

(30) Priorité: 03.07.2008 FR 0803792; 11.09.2008 FR 0804996
(43) Date de publication de la demande: 06.01.2010
(73) Titulaire: SOMFY ACTIVITES SA, 74300 Cluses (FR)
(72) Inventeur: Castelli, Clino Trini, 20121 Milan (IT)
(74) Mandataire: Novaimo

(56) Documents cités:
- EP-A- 0 333 502
- EP-A- 1 850 482
- FR-A- 2 832 811
- US-A1- 2002 101 399

## Description

L'invention concerne le domaine de l'appareillage électrique de type terminal dans un bâtiment. Elle s'applique en particulier au domaine des interrupteurs de type électronique utilisés pour la commande des dispositifs de confort thermique et visuel ou de sécurité dans un bâtiment.

Par appareillage électrique de type terminal, il faut entendre les dispositifs de commande, directement utilisables par l'occupant d'un bâtiment, à savoir : interrupteurs de commande.

Selon les cas, les dispositifs de commande sont reliés à des câbles électriques circulant dans le bâtiment ou sont autonomes et communiquent par radio ou autre moyen de communication sans fil. Les câbles sont de type « courants forts » (par exemple réseau 230 V 50 Hz) ou de type « courants faibles » (par exemple câble téléphone ou Ethernet). Les dispositifs de commande peuvent être de type mural ou de type nomade.

L'aspect esthétique est particulièrement important dans l'habitat, où ce type d'équipement participe à la décoration intérieure. Une réponse à la contrainte esthétique est l'approvisionnement des équipements auprès d'un constructeur unique. Un premier problème rencontré par ce constructeur est de garantir l'homogénéité visuelle entre les différences pièces visibles d'un même équipement : en général au moins un cadre extérieur, permettant de masquer le raccordement de l'équipement avec le mur, et une partie centrale comprenant la prise ou l'interrupteur proprement dits. Or, il suffit de variations très faibles dans les teintes pour que le ressenti visuel donne une impression de non-qualité.

A l'opposé, il est connu de donner au cadre et à la partie centrale des aspects suffisamment différents pour que le problème ne se pose plus. Dans cette logique, la partie centrale est par exemple noire dans tous les produits de la gamme, et seul le cadre est susceptible de variations de couleur dans une palette suffisante pour s'accorder aux différents styles de l'habitat. Il en résulte de plus une économie substantielle en références et en stocks pour le fabricant.

Malgré son apparente neutralité, la couleur noire elle-même présente de nombreuses variantes d'aspect selon l'état de surface et le caractère mat ou brillant du revêtement utilisé, qui peuvent nuire à certaines associations.

On trouve, en pire, ce problème d'adéquation esthétique lorsqu'il s'agit de combiner, dans une même local, des appareillages provenant de différents fabricants. La solution généralement retenue par les fabricants de deuxième rang est de simplement proposer aux électriciens leurs produits sous forme de partie centrale, afin qu'ils puissent être intégrés dans les différents cadres des fabricants de premier rang. Ceci est rendu d'autant plus facile que les dimensions internes des cadres tendent à se normaliser dans certains pays. L'avantage pour les fabricants de deuxième rang est de même de n'avoir qu'une seule référence de partie centrale, pouvant se combiner avec une multitude de cadres. Encore faut-il là aussi que cette partie centrale présente un aspect permettant la combinaison avec toutes les teintes de cette palette.

On connaît du document EP 1 850 482 un interrupteur de type capacitif comprenant une plaque de verre sous laquelle se trouve un capteur capacitif. Il est prévu que la plaque soit opaque ou peinte ou revêtue ou colorée.

On connaît du document EP 33 502 un panneau de signalisation rétro-éclairé apte à fonctionner en lumière naturelle et comprenant une plaque de rétro-réfléchissante recouverte par une partie visible de signalisation.

On connaît du document US 2002/101 399 un dispositif d'écran à cristaux liquides tactile et rétro-éclairé. Il comprend une plaque interne comportant un relief périodique sur sa face interne pour les besoins du rétro-éclairage.

On connaît du document FR 2 832 811 une plaque transparente texturée avec des reliefs périodiques permettant notamment de servir comme diffuseur de lumière dans les écrans à cristaux liquides et les lampes à plasma, la face extérieure de la plaque étant texturée.

L'invention a pour but de remédier à ce premier problème.

Un deuxième problème résolu par l'invention est celui des traces de doigts sur la partie centrale. Dans certains designs, la partie centrale doit présenter une ligne aussi pure que possible. Le verre dépoli est parfois utilisé, ou encore un revêtement métallique doré, argenté ou cuivré, avec une surface mate ou brillante.

Une plaque plane uniforme et lisse est particulièrement révélatrice de traces de doigt et nécessite un entretien fréquent. Outre le risque de fausses commandes désagréables pour la personne qui se charge de ce nettoyage, il ne faut pas sous-estimer le risque électrique pour peu que cette personne ait la mauvaise idée d'utiliser un produit nettoyant conducteur.

Un troisième problème auquel répond particulièrement l'invention est celui des équipements terminaux de type autonome ou de type électronique pour la commande des dispositifs de confort thermique et visuel ou de sécurité. De tels dispositifs sont des appareils d'éclairage, de chauffage climatisation ou ventilation, de protection solaire, des appareils de fermeture comme des volets roulants.

Les interrupteurs de type électronique permettent d'établir un contact électrique ou d'envoyer un ordre de commande à partir d'une action manuelle de faible intensité, par exemple un appui léger sur une touche de commande ou un simple effleurement d'une zone. Dans certains cas, l'action manuelle ne nécessite pas un contact franc du doigt avec une partie de l'interrupteur mais une simple proximité de celui-ci. L'interrupteur est de préférence mural, mais peut aussi être de type nomade (télécommande).

Le brevet DE 101 10 759 décrit un tel interrupteur mural de type électronique, comprenant par exemple des détecteurs à effet capacitif. Pour des raisons esthétiques, la face avant de l'interrupteur mural est constituée par une plaque de verre, ce qui confère à l'interrupteur une ligne sobre et dépouillée. Un verre dépoli est généralement utilisé.

Dans certains cas, il est souhaité donner un éclat de type métallique à la face avant d'un interrupteur mural. Cependant, la présence d'une métallisation dégrade fortement la sensibilité d'un capteur de type capacitif lorsque l'interrupteur contient un tel capteur. Par ailleurs, une métallisation peut également faire écran à l'émission d'ondes radioélectriques lorsque l'interrupteur contient un émetteur de télécommande.

Il est connu du brevet US 6,765,149 de disposer une plaque transparente sur un interrupteur mural, la plaque transparente étant munie de reliefs sur sa face interne afin de favoriser la diffraction. L'objectif est de permettre un rétro-éclairage de la plaque avec diffusion homogène de la lumière émise par plusieurs diodes électroluminescentes alimentées en série, afin que l'interrupteur soit visible dans l'obscurité.

Il est connu de la demande de brevet WO 2007/095938 d'intercaler plusieurs plaques sur un cadre d'interrupteur électrique, une des plaques étant perforée sous la forme d'un réseau de trous permettant d'insérer des éléments cristallins formant un motif visuel à la manière d'une mosaïque.

Il est connu de la demande de brevet GB 2 316 537 d'utiliser une plaque en polymère dont la partie inférieure comprend un réseau de reliefs pyramidaux. Sous l'effet de l'écrasement de ces reliefs provoqué localement par le doigt, la résistance électrique de contact diminue.

Il est connu de la demande de brevet US 2007/0247338 de disposer un masque mécanique permettant de sélectionner les contacts électriques activables par l'appui sur les différentes parties d'une plaque souple.

Aucune de ces configurations ne se rapporte aux problèmes mentionnés plus haut.

Le but de l'invention est de fournir un dispositif de commande remédiant à ces problèmes et améliorant les dispositifs connus de l'art antérieur. En particulier, l'invention propose une partie centrale d'appareillage permettant de donner à une face non métallique un éclat de type métallique et/ou un aspect s'accordant à une large palette de couleurs différentes et d'éviter que cette face soit révélatrice des éventuelles traces de doigts des utilisateurs.

Le dispositif de commande selon l'invention est défini par la revendication 1. Différents modes de réalisation du dispositif de commande sont définis par les revendications dépendantes 2 à 10.

Le dessin annexé représente, à titre d'exemple, des modes de réalisation d'un appareillage électrique selon l'invention.
La figure 1 est une vue éclatée d'un premier mode de réalisation d'un premier appareillage électrique de type terminal selon l'invention.
La figure 2 est une vue en coupe partielle d'une plaque du premier mode de réalisation, au niveau d'un relief de cette plaque.
La figure 3 est une vue en perspective d'un exemple pour un interrupteur mural.
La figure 4 est une vue en perspective d'un deuxième mode de réalisation d'un deuxième appareillage électrique selon l'invention.
La figure 5 est une vue en coupe partielle d'une plaque d'une variante des modes précédents, au niveau d'un élément de guidage de lumière.

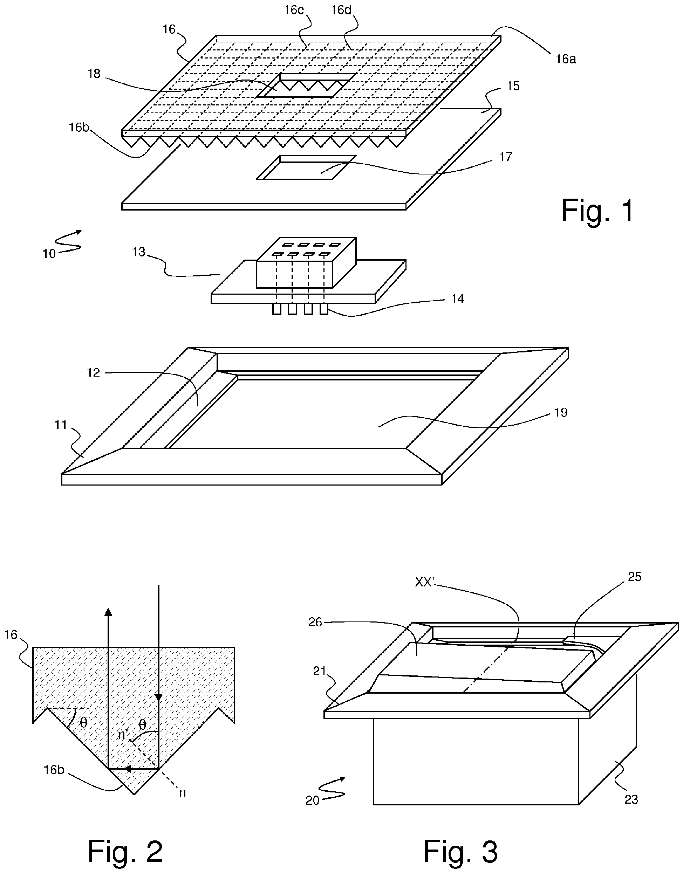

Un appareillage électrique 10, de type terminal, est représenté en perspective, dans un plan horizontal alors qu'il est destiné à être fixé sur un mur vertical, à la figure 1. Cet appareillage mural est une prise électrique, ici de type « courants faibles ».

L'appareillage électrique 10 comprend un cadre 11, délimitant une partie centrale 19. Le cadre est muni d'un support 12 permettant le maintien d'un composant électrique 13 dans la partie centrale 19 à l'intérieur du cadre ou permettant inversement de fixer le cadre au composant électrique. Ce mode de fixation est sans incidence sur l'invention et n'est pas représenté. Le composant électrique est une prise électrique et il comprend en particulier un ou plusieurs contacts électriques 14, destinés à être raccordés aux conducteurs d'un câble électrique.

Une feuille opaque 15 isolante électriquement, de faible épaisseur, recouvre en partie le composant électrique 13 et la partie centrale 19. Cette feuille opaque peut être rigide ou souple, de forte épaisseur ou de faible épaisseur comparée à l'épaisseur du support. Elle est représentée rigide et d'épaisseur importante sur la figure 1. La feuille opaque 15 peut elle-même avoir une fonction de support intermédiaire entre le support et le composant électrique ou directement entre le cadre et le composant électrique.

Une plaque transparente 16 recouvre la feuille opaque.

La feuille opaque et la plaque transparente sont respectivement munies d'un premier évidement 17 et d'un deuxième évidement 18 afin de permettre la traversée d'une partie du composant électrique.

La plaque transparente est lisse sur sa face externe 16a. La face interne, disposée en vis-à-vis de la feuille opaque, comprend au contraire la répétition d'un relief périodique 16b, préférentiellement de type pyramidal, et formant un réseau ou pavage s'étendant sur l'ensemble de la plaque transparente, comme représenté par les lignes 16c et 16d en traits pointillés. L'ensemble de la plaque transparente est de préférence réalisée en une opération de moulage d'une même matière plastique transparente. De préférence, la plaque transparente recouvre toute la partie centrale. Dans certaines réalisations, la plaque transparente peut également recouvrir le cadre 11, de manière à présenter une surface aussi dépouillée que possible.

Par matière transparente, on entend aussi bien une matière parfaitement transparente que légèrement teintée ou légèrement diffusante, selon l'effet visuel recherché.

La feuille opaque est préférentiellement noire ou blanche. Dans le premier cas, la plaque transparente peut être teintée en noir ou en brun par exemple. Dans le deuxième cas, la plaque transparente peut être teintée en blanc de manière à présenter un aspect laiteux légèrement diffusant.

De manière surprenante, il apparaît qu'une plaque transparente munie de reliefs (du type décrit précédemment ou des types décrits plus bas) et légèrement teintée en blanc dans la masse du matériau transparent, s'accorde beaucoup mieux avec des cadres blancs de nuances différentes que ne le fait une plaque non munie de ces reliefs périodiques. Autrement dit, l'invention permet d'obtenir l'aspect de neutralité ou de « non-couleur » favorisant les associations avec le reste des constituants de l'appareillage et favorisant qui plus est l'association avec l'environnement décoratif de la pièce où cet appareillage est installé. Autrement dit, il est possible d'obtenir une neutralité visuelle de la plaque permettant d'associer l'appareillage électrique selon l'invention avec une grande variété de couleurs.

Chaque relief périodique 16b peut être muni de légères stries orientées selon les lignes 16c ou 16d.

La feuille opaque 15 peut être constituée par un dépôt de peinture ou autre revêtement opaque sur la face interne de la plaque transparente 16, mais cette alternative peut présenter des problèmes d'adhésion de la peinture ou du revêtement et empêche l'utilisation d'une même plaque transparente 16 dans des configurations visuelles différentes provoquées par le changement de feuille opaque 15.

Un avantage de l'invention est donc de permettre une grande variété de configurations visuelles selon le type d'association entre plaque transparente et feuille opaque.

La figure 2 représente partiellement la plaque transparente 16, selon un plan de coupe perpendiculaire au plan principal de cette plaque et passant par le sommet d'un relief 16b. Les reliefs sont par exemple de type pyramidal ou de type sensiblement pyramidal, notamment de type pyramidal à base carrée. Néanmoins, les reliefs peuvent être pyramidaux à base polygonale autre que carrée, comme par exemple à base triangulaire ou à base hexagonale. Les reliefs peuvent aussi être coniques ou sensiblement coniques, notamment coniques de révolution.

Les axes principaux des reliefs sont perpendiculaires au plan de la plaque transparente. Ils peuvent aussi être légèrement inclinés par rapport à cette direction. La direction des axes principaux ou la forme des reliefs peuvent varier : par exemple chaque relief d'un premier type (par exemple conique) peut être entouré par des reliefs d'un deuxième type (par exemple pyramidal), par exemple sous la forme d'un damier. De manière générale, une maille de relief périodique peut comprendre plusieurs reliefs élémentaires de type différent.

De préférence, les reliefs sont agencés de sorte que la lumière du jour à laquelle est exposée la face externe de la plaque soit au maximum reflétée au niveau du relief pour être de nouveau dirigée hors de la plaque au travers de la face externe. Pour ce faire, l'angle θ d'une face inclinée de la pyramide (ou d'une génératrice de cône) avec le plan principal de la plaque est pris de préférence supérieur à l'angle de réfraction limite caractéristique de la transition entre le matériau de la plaque et l'air.

Cet angle θ est également l'angle d'incidence, sur la face inclinée d'un relief, d'un rayon lumineux arrivant perpendiculairement au plan principal de la plaque, l'angle étant mesuré par rapport à une normale nn' à cette face inclinée. Dans ces conditions le rayon incident est intégralement réfléchi. Des rayons lumineux d'incidence supérieure sont également réfléchis en totalité, par contre des rayons d'incidence inférieure sont partiellement réfractés et éclairent partiellement la feuille opaque.

La plaque transparente 16 se présente donc de loin comme un réseau de miroirs, ce qui lui confère un aspect métallique, aspect renforcé par un choix de feuille opaque sombre (par exemple noire) et atténué par un choix de feuille opaque claire (par exemple blanche).

Il est à noter que cette réflexion totale a lieu également dans l'autre sens, ce qui donne un caractère facultatif à la feuille opaque 15.

Les câbles électriques présentant très souvent des couleurs très vives, il est parfois souhaité les voir de manière très atténuée et divisée et/ou dispersée par les réflexions-réfractions multiples, dans le cas où la réflexion totale n'est qu'approximative, de manière à donner un aspect surprenant et légèrement aléatoire à l'équipement électrique.

La face externe lisse et non-métallique d'une plaque comprenant, sur sa face interne, une répétition d'un relief périodique a un éclat de type métallique et/ou un aspect s'accordant à une large palette de couleurs différentes et est telle qu'elle évite d'être révélatrice d'éventuelles traces de doigts des utilisateurs

Dans le cas d'un relief pyramidal à base carrée, chaque relief constitue 4 pixels et l'ensemble vu de loin constitue donc en fait 4 réseaux de pixels sensiblement identiques. Ainsi, les éventuelles traces de doigt sur la face externe lisse de la plaque transparente sont fragmentées par ces réflexions multiples qui les rendent moins visibles et en atténuent fortement le désagrément.

La figure 3 représente un exemple d'un interrupteur mural 20, de type mécanique. L'interrupteur mural comporte de nouveau un cadre 21. Dans cet exemple, un levier de commande 26 permet d'agir sur le composant électrique 23 comprenant un contact électromécanique à bascule, non représenté. L'interrupteur mural 20 est de type double, c'est-à-dire qu'il comprend un autre levier de commande, non représenté.

Alternativement, l'interrupteur peut être de type simple et dans ce cas le levier de commande recouvre l'ensemble de la partie centrale du cadre 1.

Dans des variantes de réalisation, le levier de commande peut recouvrir la totalité du cadre.

Selon l'exemple, le levier de commande 26 est réalisé sous forme d'une plaque transparente présentant des caractéristiques identiques à la plaque transparente 16, et de préférence associée à une feuille opaque 25. La feuille opaque peut suivre le mouvement du levier de commande ou être indépendant de celui-ci.

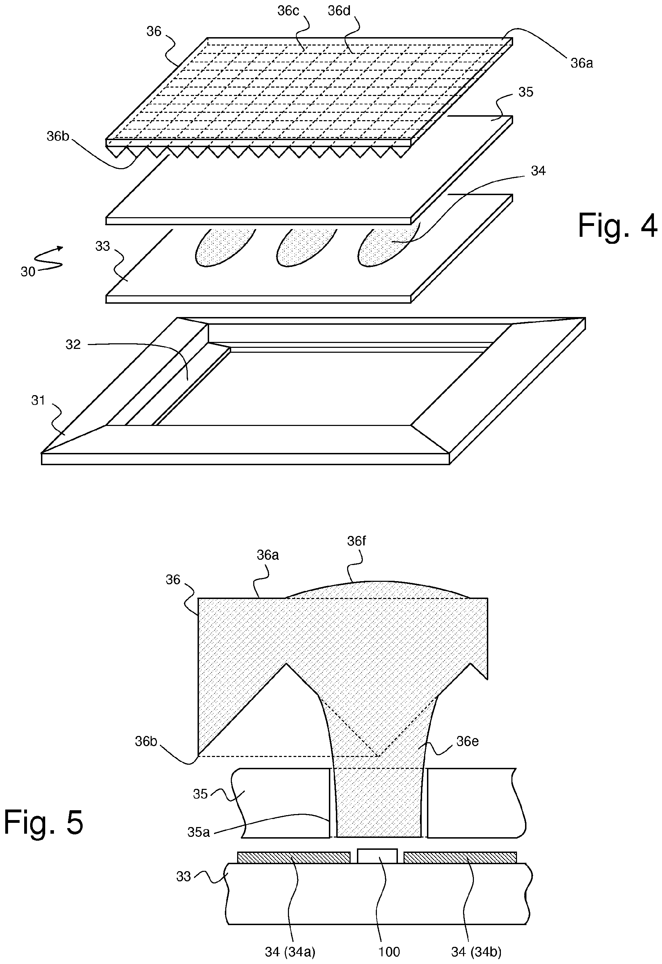

La figure 4 représente un deuxième mode de réalisation, dans le cas où l'appareillage électrique 30 est un interrupteur électronique.

L'interrupteur électronique 30 comprend un cadre 31 muni d'un support 32 permettant le maintien d'un circuit électronique 33 à l'intérieur du cadre. Le cadre sert de support au circuit électronique. Le circuit électronique comprend en particulier un ou plusieurs capteurs 34, par exemple de type capacitif. Un tel capteur présente une surface métallisée. La présence d'un doigt au-dessus de cette surface suffit à modifier la capacité d'un circuit résonnant, et donc à faire varier sa fréquence de résonance, ce déplacement de fréquence permettant de conclure à la présence du doigt.

Une feuille opaque 35 isolante électriquement, de faible épaisseur, recouvre au moins le circuit électronique 33. Cette feuille opaque peut être rigide ou souple. Elle est représentée rigide et d'épaisseur importante sur la figure 4.

Une plaque transparente 36 recouvre la feuille opaque. Comme dans les modes de réalisation précédents (16, 26) cette plaque est lisse sur sa face externe 36a. La face interne, disposée en vis-à-vis de la feuille opaque, comprend au contraire la répétition d'un relief périodique 36b, préférentiellement de type pyramidal, et formant un réseau ou pavage s'étendant sur l'ensemble de la plaque transparente, comme représenté par les lignes 36c et 36d en traits pointillés.

Il est possible, dans une variante de réalisation sans ajout de pièces, également applicable aux autres modes, de donner une fonction visuelle particulière de signalisation à certains points de la plaque transparente, par exemple au centre d'une touche virtuelle de la plaque, c'est-à-dire au centre de la zone placée au-dessus d'un capteur 34.

Une telle variante est représentée en figure 5, également en coupe. Au centre du capteur 34 est disposée une diode électroluminescente 100 ou LED. La feuille opaque 35 comprend un évidement 35a au droit de la LED. La plaque transparente 36 est conformée de manière à présenter un guide de lumière 36e en remplacement d'un ou plusieurs des reliefs 36b et traversant l'évidemment 35a.

La face supérieure 36a de la plaque transparente 36 est légèrement bombée au droit du guide de lumière, de manière à former une lentille 36f. La présence de la lentille 36f non seulement permet de délimiter une zone de « voyant » et de focaliser les rayons issus du guide de lumière, mais permet aussi à l'utilisateur de repérer tactilement l'emplacement du centre de la touche virtuelle de commande.

Alternativement, cette configuration de la figure 5 peut être utilisée pour établir un contact mécano-électrique, par exemple en pressant une micro-coupelle (remplaçant la LED 100) avec l'extrémité du guide de lumière 36e, ou encore en établissant avec celui-ci un contact pressant entre les deux zones 34a et 34b du capteur 34. Dans ce cas, la plaque transparente est légèrement flexible.

Dans une variante du cas précédent, la pression sur la micro-coupelle est effectuée par une mini-touche insérée dans un évidemment de la plaque transparente au droit de cette micro-coupelle.

Le cadre peut déborder largement par rapport au circuit électronique et aux plaques, ces éléments ayant les mêmes dimensions de manière à être compris dans le cadre une fois montés, comme en figure 4. Inversement, les bords du cadre peuvent être réduits au minimum et les plaques peuvent recouvrir la totalité du cadre, comme décrit dans le brevet DE 101 10 759.

Dans tous les cas, le cadre lui-même peut présenter la même structure que la plaque transparente, avec ou sans une feuille opaque sous le cadre. L'ensemble de l'équipement électrique s'accorde alors avec son environnement.

Les plaques transparentes 16, 26, 36 sont de préférence visibles en totalité.

De préférence, seules les faces externes 16a, 26a, 36a peuvent être éclairées dans leur globalité.

Les faces externes 16a, 26a, 36a sont accessibles aux doigts des utilisateurs, pour permettre une action de commande ou de connexion.

De préférence, la dimension d'une maille élémentaire de relief périodique est comprise entre 1 mm et 4 mm, de préférence entre 2 mm et 3 mm. De préférence, la hauteur du relief périodique est comprise entre 0.2 mm et 3 mm, de préférence entre 0.8 mm et 2.0 mm.

La plaque munie du relief périodique n'est pas destinée à faire partie d'un dispositif de rétro-éclairage, une plaque de dispositif de rétro-éclairage ayant au contraire de la plaque du dispositif selon l'invention des propriétés telles que des rayons issus d'une source de lumière située du côté de la face interne puissent pénétrer dans la plaque.

La plaque transparente et/ou la feuille opaque ont une fonction technique de décoration : celle de cacher ou masquer, au moins partiellement, un composant électrique et d'empêcher un contact entre ce composant électrique et le doigt d'un utilisateur.

L'invention a été décrite dans le cas d'un appareillage électrique tel un interrupteur mural mais s'applique également à un interrupteur nomade, par exemple une télécommande radiofréquences.

Dans le cas d'une télécommande radiofréquences, l'appareillage comprend un boîtier généralement formé d'une partie supérieure supportant les touches de commande et d'une partie inférieure fermant le boîtier. Ces deux parties sont bombées au moins dans leurs zones de raccordement. Les deux parties sont alors réalisées selon la structure de la plaque transparente, tout en approchant cette structure dans les parties bombées et/ou surfaces gauches en s'efforçant d'avoir un axe principal des reliefs toujours sensiblement perpendiculaire au plan tangent à la plaque transparente. Ceci est d'autant plus facilement réalisable que la dimension des reliefs est faible devant les rayons de courbure des parties bombées.

L'interrupteur électronique peut comporter un capteur 34 sensible à d'autres paramètres que la présence d'un doigt, par exemple un capteur de température.

## Revendications

1. Dispositif de commande (10, 20, 30) pour le bâtiment comprenant un composant électrique (13, 23, 33), **caractérisé en ce que** le composant électrique est au moins partiellement recouvert par une plaque transparente (16, 26, 36), cette plaque étant lisse sur sa face externe (16a, 26a, 36a) et comprenant une répétition d'un relief périodique (16b, 26b, 36b) sur sa face interne permettant de donner à la face externe non métallique un éclat de type métallique, **en ce que** le relief est de type pyramidal ou conique, **en ce que** l'angle des faces des pyramides ou des génératrices des cônes avec le plan principal de la plaque transparente est supérieur à l'angle de réfraction limite entre le matériau de la plaque et l'air, **en ce que** le composant électrique est un circuit électronique et **en ce que** le circuit électronique comprend au moins un capteur de type capacitif et/ou au moins un émetteur radiofréquences.

2. Dispositif de commande selon la revendication 1, **caractérisé en ce que** la plaque transparente est teintée et/ou diffusante.

3. Dispositif de commande selon l'une des revendications précédentes, **caractérisé en ce qu'**un ou certains reliefs sont remplacés par un guide de lumière (36e).

4. Dispositif de commande selon l'une des revendications précédentes, **caractérisé en ce qu'**une forme lenticulaire (36f) de diamètre sensiblement égal à la diagonale de la base d'un relief est disposée sur la face externe de la plaque transparente.

5. Dispositif de commande selon l'une des revendications précédentes, **caractérisé en ce que** la plaque transparente est entourée par un cadre (11, 21, 31).

6. Dispositif de commande selon l'une des revendications 1 à 5, **caractérisé en ce que** la plaque transparente recouvre un cadre (11, 21, 31).

7. Interrupteur électrique constitué par un dispositif de commande selon l'une des revendications 1 à 6, le composant électrique étant un interrupteur électromécanique, la plaque transparente (26) étant mobile autour d'un axe (XX') et faisant partie d'un levier de commande de l'interrupteur.

8. Interrupteur électronique constitué par un dispositif de commande selon l'une des revendications 1 à 6, **caractérisé en ce que** le circuit électronique est totalement recouvert par la plaque transparente.

9. Interrupteur mural selon l'une des revendications 7 à 8.

10. Interrupteur nomade selon l'une des revendications 7 à 8.

## Patentansprüche

1. Steuervorrichtung (10, 20, 30) für das Gebäude, welche eine elektrische Komponente (13, 23, 33) umfasst, **dadurch gekennzeichnet, dass** die elektrische Komponente wenigstens teilweise von einer durchsichtigen Platte (16, 26, 36) bedeckt ist, wobei diese Platte auf ihrer Außenseite (16a, 26a, 36a) glatt ist und eine Wiederholung eines periodischen Reliefs (16b, 26b, 36b) auf ihrer Innenseite umfasst, die es ermöglicht, der nicht metallischen Außenseite einen Glanz von metallischem Typ zu verleihen, dadurch, dass das Relief vom pyramidalen oder konischen Typ ist, dadurch, dass der Winkel der Seitenflächen der Pyramiden oder der Erzeugenden der Kegel mit der Hauptebene der durchsichtigen Platte größer als der Grenzbrechungswinkel zwischen dem Material der Platte und der Luft ist, dadurch, dass die elektrische Komponente eine elektronische Schaltung ist, und dadurch, dass die elektronische Schaltung wenigstens einen Sensor vom kapazitiven Typ und/oder wenigstens einen Funkfrequenzsender umfasst.

2. Steuervorrichtung nach Anspruch 1, **dadurch gekennzeichnet, dass** die durchsichtige Platte gefärbt und/oder lichtstreuend ist.

3. Steuervorrichtung nach einem der vorhergehenden Ansprüche, **dadurch gekennzeichnet, dass** ein oder einige Reliefs durch einen Lichtleiter (36e) ersetzt sind.

4. Steuervorrichtung nach einem der vorhergehenden Ansprüche, **dadurch gekennzeichnet, dass** eine linsenförmige Form (36f) mit einem Durchmesser, der im Wesentlichen gleich der Diagonale der Grundfläche eines Reliefs ist, auf der Außenseite der durchsichtigen Platte angeordnet ist.

5. Steuervorrichtung nach einem der vorhergehenden Ansprüche, **dadurch gekennzeichnet, dass** die durchsichtige Platte von einem Rahmen (11, 21, 31) umgeben ist.

6. Steuervorrichtung nach einem der Ansprüche 1 bis 5, **dadurch gekennzeichnet, dass** die durchsichtige Platte einen Rahmen (11, 21, 31) bedeckt.

7. Elektrischer Schalter, welcher aus einer Steuervorrichtung nach einem der Ansprüche 1 bis 6 besteht, wobei die elektrische Komponente ein elektromechanischer Schalter ist, wobei die durchsichtige Platte (26) um eine Achse (XX') beweglich ist und Bestandteil eines Bedienhebels des Schalters ist.

8. Elektronischer Schalter, welcher aus einer Steuervorrichtung nach einem der Ansprüche 1 bis 6 besteht, **dadurch gekennzeichnet, dass** die elektronische Schaltung vollständig von der durchsichtigen Platte bedeckt ist.

9. Wandschalter nach einem der Ansprüche 7 bis 8.

10. Mobiler Schalter nach einem der Ansprüche 7 bis 8.

## Claims

1. Control device (10, 20, 30) for a building comprising an electrical component (13, 23, 33), **characterized in that** the electrical component is at least partially covered by a transparent plate (16, 26, 36), this plate being smooth on its outer face (16a, 26a, 36a) and comprising a repetition of a periodic relief (16b, 26b, 36b) on its inner face that makes it possible to give the non-metallic outer face a lustre of metallic type, **in that** the relief is of pyramidal or conical type, **in that** the angle of the faces of the pyramids or of the generatrices of the cones with the main plane of the transparent plate is greater than the critical angle of refraction between the material of the plate and the air, **in that** the electrical component is an electronic circuit and **in that** the electronic circuit comprises at least one sensor of capacitive type and/or at least one radio frequency transmitter.

2. Control device according to Claim 1, **characterized in that** the transparent plate is tinted and/or diffusing.

3. Control device according to one of the preceding claims, **characterized in that** one or some reliefs are replaced by a light guide (36e).

4. Control device according to one of the preceding claims, **characterized in that** a lenticular form (36f) of diameter substantially equal to the diagonal of the base of a relief is arranged on the outer face of the transparent plate.

5. Control device according to one of the preceding claims, **characterized in that** the transparent plate is surrounded by a frame (11, 21, 31).

6. Control device according to one of Claims 1 to 5, **characterized in that** the transparent plate covers a frame (11, 21, 31).

7. Electrical switch composed of a control device according to one of Claims 1 to 6, the electrical component being an electromechanical switch, the transparent plate (26) being mobile about an axis (XX') and forming part of a control lever of the switch.

8. Electronic switch composed of a control device according to one of Claims 1 to 6, **characterized in that** the electronic circuit is totally covered by the transparent plate.

9. Wall switch according to one of Claims 7 to 8.

10. Roaming switch according to one of Claims 7 to 8.
